# FASCICULE DE BREVET EUROPEEN

(11) **EP 0 552 830 B1**
(45) Date de publication et mention de la délivrance du brevet: **10.04.1996**
(21) Numéro de dépôt: 93200073.0
(22) Date de dépôt: 13.01.1993
(51) Int. Cl.: H05K 3/38, C23C 18/40, C23C 22/83

(54) **Procédé pour promouvoir l'adhérence entre différentes couches dans la fabrication des circuits imprimés feuilletés, et compositions pour la mise-en-oeuvre de ce procédé**
Verfahren zur Verbesserung der Adhäsion zwischen verschiedenen Schichten in der Herstellung laminierter Leiterplatten und Zusammensetzungen zur Durchführung des Verfahrens
Process for improving the adhesion between different layers in the fabrication of laminated printed circuits, and compositions for carrying out this process

(30) Priorité: 21.01.1992 IT TO920036
(43) Date de publication de la demande: 28.07.1993
(73) Titulaire: ALFACHIMICI s.r.l., I-10024 Moncalieri (Torino) (IT)
(72) Inventeur: Tomaiuolo, Francesco, Dr., I-10024 Moncalieri To (IT); Ebranle, Antonella, Dr., I-10147 Torino (IT); Capano, Michele, I-10040 Rivalta To (IT)
(74) Mandataire: Patrito, Pier Franco, Dr. Ing.

(56) Documents cités:
- EP-A- 0 189 913
- EP-A- 0 321 067
- DE-A- 3 144 157
- US-A- 3 436 233

## Description

La présente invention a pour objet un procédé pour promouvoir fortement l'adhérence entre une surface de cuivre et un matériau polymérique, procédé destiné à être employé dans les techniques de fabrication des circuits imprimés feuilletés (c'est à dire à plusieurs couches); les procédés pour la fabrication de circuits imprimés feuilletés incluant ledit procédé de promotion de l'adhérence; ainsi que les compositions destinées à permettre la mise-en-oeuvre de ces procédés industriels.

On sait que les circuits imprimés feuilletés ont pris une grande diffusion parce qu'ils autorisent la réalisation d'une grande densité d'empaquetage et, de ce fait, ils satisfont les exigences présentes de miniaturisation des circuits.

Dans les techniques de fabrication des circuits imprimés feuilletés on prépare d'abord séparément les différents plans intermédiaires (couches internes) en utilisant des substrats polymériques à base de résine époxyde, de résine polyimide, de résine phénolique ou de résine polyester, revêtus sur les deux pans par une mince couche de cuivre. Sur ces couches de cuivre on forme des circuits imprimés en utilisant la technique traditionnelle prévoyant la déposition, sur toute la surface de cuivre, d'une couche de photorésist positif, par exemple de l'ainsi-dit "dry-film", qui est exposé et ensuite développé, ainsi imprimant la figure d'un plan de circuit. Ensuite on pourvoit à l'attaque du cuivre en milieu acide ou alcalin, dans les régions non protégées par le photorésist, puis on procède à l'ablation du photoresist, ainsi obtenant enfin la figure en cuivre du plan correspondant du circuit.

Une ou plusieurs couches internes ainsi préparées sont empaquetées en les séparant l'une de l'autre par des feuilles de matériau polymérique non conductif, comme par exemple l'ainsi-dit "prepreg", constitué par un tissu de fibres de verre imprégné par de la résine époxyde partiellement polimérisée. Sur les pans extérieurs de ce paquet on applique d'habitude deux minces feuilles de cuivre. L'ensemble est ensuite laminé sous une action combinée de chaleur et de pression, ainsi provoquant la fusion de la résine, laquelle remplit tous les interstices entre les couches internes et ensuite polymérise en consolidant définitivement l'ensemble. Cette lamination est effectuée d'habitude sous une pression d'environ 50-60 kg/cm, à une température comprise entre 170 et 200 °C et pendant un temps compris entre 1 et 4 heures.

Le circuit feuilleté ainsi obtenu est percé afin d'obtenir des trous traversants, dans le nombre et dans les points prévus. On pourvoit ensuite à la levée ("desmear") des résidus de l'opération de perçage qui peuvent se trouver sur les parois des trous et, particulièrement, en correspondance des couches internes de cuivre, puis on pourvoit à la métallisation des trous traversants (procédé PTH) dans le but de connecter électriquement les différentes couches internes de cuivre du circuit, entr'elles et avec les pans extérieurs. D'habitude, le circuit ainsi préparé doit être encore soumis à un traitement électrolytique de déposition de cuivre et d'alliage étain-plomb. Enfin on lève sélectivement, par une opération d'attaque chimique, le cuivre des pans extérieurs, jusqu'à obtenir la figure finale du circuit désiré.

Du fait que bien souvent on rencontre des problèmes de délamination entre la surface de cuivre des couches internes et les couches intermédiaires de matériau polymérique, afin d'augmenter l'adhérence on procède d'habitude à une oxidation des conducteurs de cuivre. Par ce traitement on augmente l'aire de la surface de cuivre, et donc on améliore la possibilité d'ancrage pour le matériau polymérique. Le traitement d'oxidation des surfaces de cuivre, bien qu'il a été employé depuis longtemps avec un succès assez bon, montre essentiellement deux inconvénients. Le premier inconvénient est que l'augmentation d'adhérence qu'on obtient par ce procédé n'est pas toujours suffisante pour remédier aux problèmes de délamination entre le cuivre et le matériau polymérique. Cela s'avère parce que la couche d'oxyde obtenue est épaisse, non uniforme et mécaniquement fragile et, si elle est sollicitée thermiquement, peut se casser et donc provoquer des délaminations.

Le deuxième inconvénient consiste dans le phénomène de l'ainsi-dit anneau rose ou "aloing", plus fréquemment appelé "pink-ring", provoqué par la dissolution annulaire, autour des trous, de la couche d'oxyde de cuivre, en conséquence d'une infiltration d'acides à partir de la paroi du trou, le long des couches internes de cuivre. Cette dissolution de la couche d'oxyde s'avère lors qu'on fait la métallisation des trous (ligne PTH) et surtout pendant la successive déposition électrolytique du cuivre et de l'alliage étain-plomb (ligne "pattern-plating"). On estime que ce phénomène de "pink-ring" soit provoqué, au moins en partie, par la présence de microdélaminations entre le cuivre et la couche polymérique autour des trous. En effet, lors qu'un circuit feuilleté est percé, du fait des sollicitations mécaniques et thermiques peuvent facilement s'avérer des microdélaminations si l'adhérence entre la surface de cuivre et la couche de matériau polymérique n'est pas optimale. Pendant la phase successive de "desmear", particulièrement si on travaille par un procédé utilisant du permanganate, ces détachements augmentent leur dimensions et, pendant les phases successives de déposition chimique de cuivre et de déposition électrolytique de cuivre et d'alliage étain-plomb, peut s'avérer le phénomène du "pink-ring".

Jusqu'ici, en utilisant un procédé d'oxidation dans le but de promouvoir l'adhérence, il n'a pas été possible d'éliminer complètement ce problème, bien qu'on a cherché de le réduire au minimum en optimisant le procédé d'oxidation, par exemple en réduisant l'épaisseur de l'oxyde et donc les dimensions des cristaux, ou en améliorant le procédé de lamination, ou bien encore en améliorant les conditions de perçage et en remplaçant souvent les pointes utilisées pour ce perçage.

On a proposé des différents procédés substitutifs de l'oxidation du cuivre, dans le but de promouvoir l'adhérence et d'éliminer le problème du "pink-ring". Un de ces procédés est décrit dans le document US-A-4,775,444, suivant lequel on prévoit, après un traitement d'oxidation du cuivre ou une déposition chimique d'étain, un traitement par une solution diluée d'acide chromique. Mais en réalité ce procédé n'est pas capable de réduire le "pink-ring" en une mesure suffisante, ni d'augmenter considérablement l'adhérence entre le cuivre et le matériau polymérique.

Un autre procédé qui a été proposé est décrit dans le document EP-A-0.189.913 qui prévoit, après une oxidation du cuivre, un traitement de réduction de l'oxyde de cuivre par un aminoborane en milieu alcalin, notamment une solution contenant du diméthylaminoborane et de l'hydroxyde de sodium comme base forte. Ce procédé autorise, en certaines conditions, l'élimination totale du problème du "pink-ring", mais il montre trois graves inconvénients. Le premier inconvénient est qu'après le traitement de réduction la surface de cuivre est très inégale. Le deuxième inconvénient est que l'aminoborane est soumis à une forte décomposition, et du fait qu'il s'agit d'un produit très coûteux, ce procédé n'est pas facilement utilisable pour des raisons économiques. Le troisième et plus grave inconvénient est que, lorsque l'épaisseur de la couche d'oxyde soumise au traitement de réduction est élevé (plus qu'environ 150 nm), le procédé ne peut pas assurer une adhérence suffisante entre le cuivre et la résine, comme il est affirmé aussi dans le document successif EP-A-0.321.067 de la même titulaire du document EP-A-0.189.913. Le document EP-A-0.321.067 décrit l'emploi d'un autre procédé, lequel prévoit un double traitement de réduction de l'oxyde de cuivre par immersion d'abord en sodium borohydrure et après en formaldéhyde. Ce procédé montre l'inconvénient d'exiger un traitement double, tandis que pas toujours dans les appareillages de production on a à disposition des cuves en nombre suffisant pour pouvoir effectuer un traitement de réduction double; de plus, à présent on a la tendance à excluder des procédés de production la formaldéhyde, qu'on soupçonne puisse avoir une action cancérogène.

Pour résoudre le problème du "pink-ring" on a aussi proposé d'employer comme promoteur d'adhérence un procédé de déposition chimique d'étain. Toutefois ce procédé n'est pas capable d'assurer une adhérence suffisante pour résister aux sollicitations thermiques plus rigoureuses, et de plus il est très coûteux et donne lieu à des graves problèmes pour le traitement des solutions épuisées, en raison de la présence de cuivre compléxé avec de la thyourée.

En vue de cette situation, le but de la présente invention est de perfectionner les procédés connus qui prévoient d'oxider la surface de cuivre et ensuite de soumettre la surface de cuivre oxidée, avant la lamination des différentes couches internes, à un traitement de réduction, de sorte à réaliser un procédé capable d'augmenter fortement l'adhérence entre une couche interne de cuivre et une couche de matériau polymérique, d'éliminer totalement ou en mesure élevée soit les problèmes de délamination que le problème du "pink-ring" et de permettre d'obtenir une surface de cuivre ayant une uniformité optimale, tout cela en des conditions économiquement et écologiquement convenables.

La présente invention a aussi pour objet un procédé pour la fabrication de circuits imprimés feuilletés, perfectionné en ce qui concerne les traitements de préparation des couches internes avant la phase de lamination, afin de promouvoir l'adhérence entre la surface de cuivre et le matériau polymérique dans la phase successive de lamination à chaud, pour produire économiquement des circuits feuilletés exempts de problèmes de "pink-ring" et capables de résister à des sollicitations thermiques rigoureuses sans donner lieu à des problèmes de micro- ou macro-délamination entre les différentes couches.

Enfin la présente invention a encore pour objet des nouvelles compositions de bains destinées à être employées dans les procédés suivant l'invention même.

Comme on l'a déjà dit, le procédé objet de la présente invention exige un traitement préliminaire d'oxidation des surfaces de cuivre des couches internes, suivant un procédé d'oxidation traditionnel. Ce procédé d'oxidation prévoit d'habitude une première phase de dégraissage des surfaces de cuivre, afin d'emporter des empreintes ou des résidus huileux, une phase de mordançage, afin de rendre rugueuses les surfaces de cuivre, une phase de décapage, afin d'emporter des résidus salins, une phase de noircissement préalable, afin de rendre alcaline la surface de cuivre pour favoriser une successive oxidation uniforme, et enfin une phase d'oxidation proprement dite, suivant un quelconque des procédés d'oxidation connus. Ces procédés d'oxidation font emploi de solutions aqueuses alcalines d'agents oxidants, tel qu'un chlorite d'un métal alcalin ou alcalino-terreux, par esemple sodium chlorite, ou bien sodium persulfate, potassium chlorate ou potassiun perchlorate. Ces solutions travaillent en général à des températures comprises entre 55 °C et 90 °C, et par une durée de traitement comprise entre 30 secondes et 10 minutes. Le traitement peut être réalisé par immersion ou bien par aspersion. Une solution capable de réaliser l'oxidation du cuivre peut avoir, par exemple, la composition typique suivante:

| | |
|---|---|
| NaClO₂: | 50-250 g/l |
| NaOH: | 10-100 g/l |
| Na₃PO₄.12H₂O: | 1- 50 g/l |
| Eau déionisée jusqu'à: | 1 l |

Par cette solution on peut obtenir un oxide de cuivre de couleur variable du bronze au noir, avec une épaisseur comprise entre 50 nm (0,05 microns) et 5000 nm (5 microns), plus typiquement comprise entre 100 nm et 800 nm. Après la phase d'oxidation de la surface de cuivre on procède à un traitement successif de réduction de la couche d'oxyde dans une solution réductrice comportant dans sa composition le diméthylaminoborane et une base forte.

L'invention concerne donc en premier lieu un procédé pour le traitement des surfaces de cuivre afin de promouvoir l'adhérence entre différentes couches dans la fabrication de circuits imprimés feuilletés, rigides, flexibles ou flexo-rigides, moyennant la formation d'une couche d'oxyde sur les surfaces de cuivre et un traitement ultérieur de réduction tion de l'oxyde de cuivre dans une solution comportant dans sa composition du diméthylaminoborane et une base forte.

Le procédé objet de la présente invention est caractérisé en ce que le traitement de réduction, successif à la phase d'oxidation de la surface de cuivre, est effectué dans une solution réductrice comportant dans sa composition, en plus du diméthylaminoborane et d'une base forte, un composé spécifique ayant fonction stabilisante et ralentissante, ledit composé étant choisi dans le groupe comprenant:
(A) Un alcoylbenzènesulfonate alcalin, à savoir un composé de la formule générale: C₆H₃.R.R'.SO₃X où R et R' peuvent être H, CH₃ ou C₂H₅, et X est un métal alcalin, spécialement Na.
(B) Un composé de la thiourée ou ses homologues de sélénium ou tellurium de la formule générale: C.Y.N₂.R¹.R.R³.R⁴ où R¹, R, R³, R⁴ peuvent être:
   (a) H,
   (b) un groupe alcoylique ou alcènilique comprenant un nombre d'atomes de carbone non supérieur à 6,
   (c) un groupe cycloalcoylique, cycloalcoylalcoylique ou alcoylcycloalcoylique comprenant un nombre d'atomes de carbone non supérieur à 12,
   (d) un groupe arylique, arylalcoylique ou alcoylarylique comprenant un nombre d'atomes de carbone non supérieur à 12,
   (e) R⁵(CO), où R⁵ peut être un quelconque des composés indiqués de (a) à (d),
   (f) CH₂OH;
et Y peut être S, Se ou Te;
(C) un composé de la thiourée avec des acides organiques ou inorganiques;
(D) un mélange de deux ou plusieurs des composés de (A) à (C).

De préférence la solution de réduction objet de la présente invention, quand elle fait usage d'un des composés indiqués sous (A), comporte dans sa composition, comme alcoylbenzènesulfonate alcalin, le sodium xylènesulfonate, un produit commercialisé par exemple par la Marchon Italia sous le nom de ELTESOL® SX 93.

De préférence la solution de réduction objet de la présente invention, quand elle fait usage d'un des composés indiqués sous (B), contient la thiourée telle quelle.

Les composés proposés par l'invention développent dans cette solution de réduction deux fonctions très importantes, l'une desquelles est de stabiliser le diméthylaminoborane, l'autre est de ralentir la réaction de réduction de l'oxyde de cuivre, en permettant d'obtenir une structure très fine de l'oxyde réduit, qui est capable de promouvoir une forte adhérence.

La concentration du dimethylaminoborane dans le bain peut changer de 0,1 g/l jusqu'à la saturation, notamment jusqu'à 100 g/l, et elle est comprise de préférence entre 0,5 g/l et 5 g/l.

La concentration du sodium hydroxyde peut changer entre 1 g/l et 100 g/l, et elle est comprise de préférence entre 10 g/l et 30 g/l.

Quand on fait usage d'un des composés indiqués sous (A), la concentration de l'alcoylbenzènesulfonate alcalin peut changer de 0,1 g/l jusqu'à la saturation, et elle est comprise de préférence entre 0,5 g/l et 5 g/l.

Quand on fait usage d'un des composés indiqués sous (B) et/ou (C), la concentration de ce composé peut changer entre 0,1 mg/l et 100 mg/l, et elle est comprise de préférence entre 0,5 mg/l et 2 mg/l.

La température de travail de ce bain de réduction peut changer entre 20 °C et 60 °C, et elle est comprise de préférence entre 20 °C et 30 °C.

La période de traitement nécessaire pour compléter la réaction de réduction de l'oxyde de cuivre change en fonction de l'épaisseur de la couche d'oxyde à traiter, de la concentration des différents composants du bain de réduction et de la température de travail, et elle peut changer entre 10 secondes et 15 minutes, mais en général elle est comprise entre 2 minutes et 6 minutes. Le complètement de la réaction de réduction de l'oxyde de cuivre est mis en évidence par l'arrêt du développement de gaz qui peut être observé dans le bain pendant la réaction de réduction.

Le traitement de réduction par la solution objet de la présente invention peut être effectué par immersion, par aspersion ou par d'autres méthodes, mais à présent on croit qu'il soit préférable l'effectuer par immersion.

La solution pour le traitement de réduction de la surface de cuivre oxidée, objet de la présente invention, est active indifféremment sur les oxydes de différentes couleurs et épaisseurs, mais elle est appliquée de préférence sur un oxyde de couleur noire dont l'épaisseur est comprise entre 300 nm et 600 nm. Quand la solution de réduction agit sur un oxyde de cette couleur et de cette épaisseur elle assure la plus grande uniformité de la surface, la plus élevée adhérence entre le cuivre et le matériau polymérique et l'élimination plus parfaite du "pink-ring", comme on mettra mieux en évidence plus avant sur la base de certaines exemples, accompagnés par des exemples comparatifs.

La couche d'oxyde de cuivre réduit suivant le procédé objet de la présente invention montre une couleur qui change du brun foncé jusqu'au noir, et une apparence toujours très uniforme. Après lamination les circuits feuilletés préparés en partant de couches internes traitées suivant ce procédé montrent toujours une couleur noire, c'est à dire comme se montrent d'habitude les circuits traités suivant la technique traditionnelle d'oxidation par oxyde noir sans traitement successif de réduction. Toutefois, au contraire des circuits feuilletés produits suivant la technique traditionnelle, les circuits feuilletés produits en utilisant des couches internes soumises au traitement de réduction objet de la présente invention sont exempts de tout phénomène de "pink-ring", du fait que l'oxyde de cuivre réduit obtenu suivant le procédé objet de la présente invention n'est pas soluble en milieu acide. De plus, après le traitement de réduction on obtient toujours une augmentation considérable de l'adhérence, du fait que l'oxyde de cuivre obtenu par ce traitement de réduction a une épaisseur et une structure cristalline de dimensions toujours bien plus réduites par rapport à l'oxyde de cuivre de départ correspondant. Par exemple, par un oxyde noir traditionnel on peut obtenir, en fonction de l'épaisseur, une résistance à la délamination ("peel-strength") comprise entre 0,1 kg/cm et 1,2 kg/cm, tandis que par l'oxyde correspondant réduit on obtient en général des valeurs comprises entre 0,8 kg/cm et 1,9 kg/cm.

On a déjà dit que le procédé de réduction de l'oxyde de cuivre décrit dans le document EP-A-0.189.913 est capable de travailler correctement sur un oxyde de cuivre dont l'épaisseur est comprise entre 50 nm et 150 nm, tandis qu'en travaillant sur une épaisseur supérieure on n'obtient pas une bonne adhérence entre la surface de cuivre des couches internes et le matériau polymérique. Toutefois il est connu dans ce domaine de la technique qu'un oxyde de cuivre ayant une épaisseur comprise entre 50 nm et 150 nm est un oxyde de couleur rouge-brune constitué par un mélange, en des rapports variables, de Cu₂O et de CuO, qui sont deux oxydes de cuivre de couleurs respectivement rouge et noire. La couche d'oxyde de couleur rouge-brune, qui représente un stade intermédiaire dans le processus d'oxidation du cuivre, n'est pas caractérisée par une composition définie et constante, et du fait que celle-ci peut changer d'un point à l'autre, la couleur de la surface des circuits résulte très peu uniforme. Quand on soumet à un traitement de réduction une couche interne de cuivre ayant un oxyde de couleur rouge-brune et d'épaisseur comprise entre 50 nm et 150 nm on obtient une adhérence élevée, mais la grande manque d'uniformité de la surface est maintenue, ou plutôt elle est mise encore plus en évidence après le traitement de réduction.

Le procédé objet de la présente invention, comme différence par rapport au procédé décrit dans le document EP-A-0.189.913, est capable de travailler correctement aussi, ou plutôt de préférence, sur un oxyde de couleur noire. Différemment de l'oxyde rouge-brun, l'oxyde noir est constitué presqu'exclusivement de CuO, et il est donc caractérisé par une composition définie et constante, qui ne change pas d'un point à l'autre sur la surface du circuit. Il s'ensuit qu'une couche interne ayant de l'oxyde noir se montre toujours avec une apparence parfaitement uniforme. Quand l'oxyde noir est soumis à un traitement de réduction suivant le procédé objet de la présente invention, l'oxyde réduit qu'on obtient montre la même parfaite uniformité de surface de l'oxyde noir précédent. Cette caractéristique est très importante parce que la manque d'uniformité de l'oxyde réduit, si elle est présente à la surface de cuivre des couches internes, peut être facilement observée après la lamination. Une telle manque d'uniformité de la surface finale n'est pas acceptée, en général, par les usagers des circuits feuilletés, et donc ces caractéristiques sont suffisantes par elles-mêmes pour faire considérer un circuit feuilleté comme de rebut. Celle-ci est l'une des raisons pour lesquelles dans le passé le procédé d'oxidation par oxyde de couleur rouge, qui donne souvent lieu à des problèmes de manque d'uniformité de la surface, a eu peu d'application dans la production des circuits imprimés feuilletés, même s'il assure une adhérence supérieure à celle de l'oxyde noir non réduit.

La raison pour laquelle il est possible d'effectuer le traitement de réduction d'un oxyde de cuivre d'épaisseur supérieure à 150 nm, c'est à dire d'un oxyde noir, en travaillant par le procédé objet de la présente invention, sans rencontrer les problèmes d'adhérence réduite qu'on avait en travaillant suivant la technique précédente, est en relation à la forte action de stabilisation developpée par les composés proposés par l'invention, surtout par le sodium xylènesulfonate. En effet, en présence de ces composés, le développement de gaz qui est normalement visible dans le bain pendant la réaction de réduction de l'oxyde de cuivre, est réduite d'une façon draconienne. Le fort développement de gaz qui a lieu lors qu'on travaille suivant le procédé décrit dans le document EP-A-0.189.913, comme indiqué dans le brevet lui-même, est l'indication d'une réaction de réduction qui a lieu d'une façon violente et qui n'autorise pas l'obtention de la structure fine de l'oxyde réduit, nécessaire pour promouvoir la plus grande adhérence entre la surface de cuivre et le matériau polymérique. Si la solution de réduction de l'oxyde de cuivre comporte dans sa composition un des composés proposés par l'invention, la réaction de réduction se développe bien plus lentement par rapport à une solution équivalente non comportant ledit produit. Cela permet d'obtenir une structure fine de l'oxyde de cuivre réduit, qui est capable d'assurer la plus grande adhérence, même lorsqu'on part d'un oxyde de cuivre de couleur noire.

Lorsqu'on fait la réduction de l'oxyde rouge, caractérisé par une épaisseur très limitée et par une structure de départ très fine, même dans l'absence d'un stabilisateur spécifique la réaction de réduction a lieu assez lentement, a une durée très limitée, et on obtient une structure finale de l'oxyde réduit suffisamment fine, capable d'assurer une bonne adhérence. Quand, au contraire, on fait la réaction de réduction de l'oxyde noir, caractérisé par une épaisseur bien plus grande, dans l'absence d'un stabilisateur spécifique la réaction se développe avec trop de violence, la structure cristalline précédente de l'oxide de cuivre a la tendance à s'exfolier, et donc la structure cristalline de l'oxyde réduit qu'on obtient n'est pas appropriée pour promouvoir l'adhérence dans la phase successive de lamination à chaud.

L'action de stabilisation développée par les composés utilisés dans le procédé suivant l'invention, en plus d'autoriser l'utilisation de l'oxyde noir et donc l'obtention d'une surface dont l'oxyde réduit montre une uniformité parfaite, assure aussi un autre avantage d'importance fondamentale, consistant en une réduction draconienne de la consommation de dyméthylaminoborane, nécessaire pour le traitement de réduction de l'oxyde de cuivre. Du fait que le dyméthylaminoborane est un produit particulièrement coûteux, la décomposition excessive qui a lieu normalement dans le bain lorsqu'on travaille sans l'action d'un stabilisateur spécifique rend économiquement désavantageuse l'utilisation industrielle de ce procédé.

L'utilisation d'un stabilisateur spécifique assure, au contraire, une forte réduction dans la consommation de dyméthylaminoborane, consommation qui se révèle inférieure du 50% par rapport à une solution travaillant sans ce stabilisateur. De plus on interdit presque totalement la décomposition du dyméthylaminoborane qui a lieu spontanément dans le bain pendant les arrêts du travail, lors qu'aucune réaction de réduction de l'oxyde de cuivre n'a lieu. De ce fait l'utilisation comme stabilisateur d'un composé suivant l'invention rend le procédé de réduction de l'oxyde de cuivre par le dyméthylaminoborane économiquement avantageuse, en plus que techniquement optimale sous les points de vue de la prévention du "pink-ring", et de l'obtention d'une surface uniforme, capable d'assurer une adhérence élevée.

L'invention concerne aussi un procédé pour la fabrication de circuits imprimés feuilletés, caractérisé en ce qu'il comprend les phases suivantes:
a) préparer un certain nombre de couches internes constituées par un substrat non conducteur, rigide ou flexible, couvert sur les deux côtés par des minces feuilles de cuivre, ledit substrat pouvant être constitué par un tissu de fibre de verre ou par du papier, imprégné par de la résine époxyde, polyimide ou phénolique, ou bien par une feuille de résine époxyde, polyimide ou phénolique.
b) Emporter sélectivement le cuivre par une opération d'attaque chimique, des deux côtés des couches internes, jusqu'à obtenir la figure du circuit interne.
c) Traiter les surfaces de cuivre desdites couches internes par un procédé tendant à promouvoire l'adhérence, comme décrit auparavant.
d) Laminer, sous l'action combinée de chaleur et de pression, un ou plusieurs couches internes, préparées suivant la procédure de a) à c), en les séparant par un ou plusieurs couches de matériau non conducteur, constitué par un tissu de fibre de verre ou par du papier, imprégné par de la résine époxyde, polyimide ou phénolique, ou bien par une feuille de résine époxyde, polyimide ou phénolique, et recouvrant leurs faces extérieures par deux feuilles de cuivre.
e) Percer le circuit feuilleté ainsi obtenu en réalisant des trous traversants, dans le nombre et dans les positions prévues.
f) Soumettre à un traitement de "desmear" et de métallisation les parois des trous traversants.
g) Emporter sélectivement le cuivre des faces extérieures par une opération d'attaque chimique, ainsi obtenant la figure de circuit désirée.

De préférence, dans ce procédé, aussi les deux feuilles de cuivre appliqués sur les faces extérieures du circuit feuilleté sont traités, avant la lamination, par un procédé tendant à promouvoir l'adhérence, comme décrit auparavant.

L'invention concerne également un procédé pour la fabrication de circuits imprimés feuilletés flexibles, comprenant les phases suivantes:
a) Coller deux feuilles de cuivre, traités suivant un procédé tendant à promouvoir l'adhérence, comme décrit auparavant, à une couche de résine flexible constituée par polyimide, polyester, polysulfone ou polytetrafluoroéthylène, en utlisant un collant à base de résine époxyde ou acrylique.
b) Emporter par un attaque chimique, de la surface de ces couches internes, le cuivre où il n'est pas requis, en obtenant la figure du circuit.
c) Traiter la surface de cuivre par un procédé tendant à promouvoir l'adhérence, comme décrit auparavant.
d) Coller un ou plusieurs couches internes flexibles préparées suivant la procédure de a) à c) en utilisant un collant à base de résine époxyde ou acrylique.

Enfin l'invention concerne les compositions destinées à permettre la mise en oeuvre des procédés susdits, ayant les caractéristiques de la revendication 14, qui sont aussi déjà indiquées dans la description des procédés.

Les exemples suivants montrent plus en détail la présente invention dans certaines applications pratiques, pour mettre en évidence sa fonctionnalité, mais il ne doivent pas être considérés comme limitatifs du domaine de la présente invention.

Dans tous les exemples indiqués ci de suite on a effectué la suivante préparation de la surface de cuivre, avant de la soumettre au traitement d'oxidation et au traitement successif de réduction:
- Traitement mécanique de ponçage.
- Traitement par un dégraissant alcalin (NICLAGI 84 produit par Alfachimici s.r.l.) préparé à la concentration de 50 g/l, pour une durée de 5 minutes à la température de 50 °C, suivi par un double lavage par de l'eau.
- Traitement par un produit de mordençage (MICROINCIDE 1207 produit par Alfachimici s.r.l.) préparé en une solution comportant 30 g/l de H₂O₂, pour une durée de 1 minute à la température de 25 °C, suivi par un seul lavage par de l'eau.
- Traitement de neutralisation en une solution de H₂SO₄ au 10%, pour une durée de 1 minute à la température de 25 °C, suivi par un seul lavage par de l'eau.
- Traitement de noircissement préalable en une solution de NaOH à l' 1%, pour une durée de 1 minute à la température de 50 °C.

### EXEMPLE 1 A

Une feuille de cuivre de l'épaisseur de 35 microns est soumis au cycle de traitement préalable susdit, après quoi il est oxidé moyennant immersion en un bain travaillant avec la suivant composition et selon les paramètres suivants:

| | |
|---|---|
| Sodium chlorite: | 120 g/l |
| Sodium hydroxyde: | 25 g/l |
| Sodium phosphate dodécahydrate: | 10 g/l |
| Eau déionisée jusqu'à: | 1 l |
| Température: | 70 °C |
| Temps de traitement: | 6 minutes |

Cette feuille de cuivre, après oxidation, montre une couleur noire et une apparence uniforme. L'épaisseur de la couche d'oxyde de cuivre, mesurée séparément en base à la perte de poids après dissolution en acide sulfurique dilué, résulte de 400 nm (0,35 mg/cm). Après l'oxidation la feuille de cuivre est soumise à un double lavage par de l'eau et puis à un traitement de réduction moyennant immersion dans un bain travaillant avec la suivante composition et selon les paramètres suivants:

| | |
|---|---|
| Diméthylaminoborane: | 1 g/l |
| Sodium hydroxyde: | 25 g/l |
| Sodium xylènesulfonate: | 0,5 g/l |
| Eau déionisée jusqu'à: | 1 l |
| Température: | 30 °C |
| Temps de traitement: | 6 minutes |

Pendant l'immersion, la réaction de réduction de l'oxyde de cuivre se développe très lentement, et en effet le développement de gaz est extrèmement limité. La réaction de réduction est complète après 6 minutes. Après le traitement de réduction la feuille de cuivre se montre d'une couleur brune très foncée et d'une apparence parfaitement uniforme. Ensuite la feuille de cuivre est soumise à un lavage, d'abord par de l'eau de réseau, puis par de l'eau déionisée, et enfin elle est essuyée par de l'air chaud à 80 °C pendant 10 minutes.

Avec la feuille de cuivre ainsi traitée on prépare un circuit feuilleté en utilisant comme base une couche interne rigide et en interposant, entre celle-ci et la feuille de cuivre, trois feuilles de "prepreg". La feuille de cuivre est collée au "prepreg" du côté traité suivant le procédé objet de la présente invention.

Le sandwich ainsi préparé est laminé suivant les paramètres habituels (55 kg/cm, 180 °C, 2 heures). Le circuit feuilleté obtenu est imprimé et attaqué pour obtenir à la surface des bandes de cuivre de largeurs comprises entre 2 mm et 10 mm. Ces bandes sont soumises à mesurage de la résistance à la délamination par l'emploi d'un dynamomètre (model CEMCO 90 produit par Circuit Engineering Marketing Co., Ltd.) en tirant les bandes sous un angle de 90° et avec une vitesse d'avancement de 25 mm/minute. Ce mesurage est effectué d'une façon répétée, soit sur le circuit feuilleté tel qu'il résulte de la production, soit après une sollicitation thermique (flottaison sur de l'alliage étain-plomb à 288 °C pour 10 secondes).

Les valeurs de la résistance à la délamination qu'on obtient sont les suivantes:
- Avant la sollicitation thermique : 1,4 - 1,6 kg/cm
- Après la sollicitation thermique : 1,3 - 1,6 kg/cm

Comme conséquence de la grande uniformité de la surface de l'oxyde réduit obtenu, la valeur de la résistance à la délamination change dans un intervalle extrêmement réduit, et elle ne change pas d'une façon substantielle après la sollicitation thermique.

### EXAMPLE 1 B

Une feuille de cuivre de l'épaisseur de 35 microns est traité comme décrit dans l'exemple 1 A, sauf que pour la réduction du cuivre oxidé on emploie un bain comportant dans sa composition la thyourée au lieu du sodium xylènesulfonate, et travaillant avec la suivante composition et selon les paramètres suivants:

| | |
|---|---|
| Diméthylaminoborane: | 1 g/l |
| Sodium hydroxyde: | 25 g/l |
| Thiourée: | 2 mg/l |
| Eau déionisée jusqu'à: | 1 l |
| Température: | 30 °C |
| Temps de traitement: | 6 minutes |

Aussi dans ce cas la réaction de réduction de l'oxyde de cuivre se développe très lentement, et en effet le développement de gaz est extrèmement limité. La réaction de réduction est complète après 6 minutes. Après le traitement de réduction la feuille de cuivre montre une couleur brune très foncée et une apparence parfaitement uniforme.

Avec la feuille de cuivre ainsi traitée on prépare un circuit feuilleté, puis on fait le mesurage de la résistance à la délamination en employant la même procédure décrite dans l'exemple 1 A. Les valeurs de la résistance à la délamination qu'on obtient sont les suivantes:
- Avant la sollicitation thermique : 1,4 - 1,7 kg/cm
- Après la sollicitation thermique : 1,4 - 1,6 kg/cm

Les valeur de la résistance à la délamination qu'on obtient dans ce cas sont pratiquement identiques à celles obtenues dans l'exemple précédent 1 A.

### EXEMPLE COMPARATIF 1

Une feuille de cuivre de l'épaisseur de 35 microns est traité comme décrit dans les exemples 1 A et 1 B, sauf que pour la réduction du cuivre oxidé on emploie un bain suivant la technique connue qui ne comporte aucun stabilisateur, à savoir, travaillant avec la suivante composition et selon les paramètres suivants:

| | |
|---|---|
| Diméthylaminoborane: | 1 g/l |
| Sodium hydroxyde: | 25 g/l |
| Eau déionisée jusqu'à: | 1 l |
| Température: | 30 °C |
| Temps de traitement: | 6 minutes |

Lorsque la feuille de cuivre ayant une surface oxidée est immersée dans ce bain on constate un fort développement de gaz indiquant une réaction violente; le bain devient trouble dû à la présence de particules noires d'oxyde de cuivre suspendu. La réaction a lieu énergiquement pendant la première minute du traitement, procède ensuite plus lentement, et se complète après 6 minutes. Après le traitement de réduction la feuille de cuivre montre une couleur rouge-brune, dont l'apparence résulte très inégale.

Avec la feuille de cuivre ainsi traitée on prépare un circuit feuilleté, puis on fait le mesurage de la résistance à la délamination en employant la même procédure décrite dans l'exemple 1 A. Les valeurs de la résistance à la délamination qu'on obtient dans ce cas sont les suivantes:
- Avant la sollicitation thermique : 0,2 - 0,7 kg/cm
- Après la sollicitation thermique : 0,01 - 0,1 kg/cm

Comme conséquence de la destruction de la microstructure cristalline de l'oxyde de cuivre, qui a lieu dans ce cas dû à l'absence d'un stabilisateur comme celui proposé par l'invention, la valeur de la résistance à la délamination change beaucoup d'un point à l'autre de la feuille de cuivre, et de plus elle se réduit d'une façon draconienne après la sollicitation thermique.

### EXEMPLE 2 A

Une feuille de cuivre de l'épaisseur de 35 microns est traité par la même procédure de l'exemple 1 A, sauf que pour l'oxidation de la surface de cuivre on emploie un bain travaillant avec la suivante composition et selon les paramètres suivants:

| | |
|---|---|
| Sodium chlorite: | 150 g/l |
| Sodium hydroxyde: | 15 g/l |
| Sodium phosphate dodécahydrate: | 20 g/l |
| Eau déionisée jusqu'à: | 1 l |
| Température: | 70 °C |
| Temps de traitement: | 3 minutes |

Cette feuille de cuivre montre, après oxidation, une couleur rouge et une apparence peu uniforme. L'épaisseur de la couche d'oxyde de cuivre qu'on obtient dans ce cas résulte de 100 nm.

Pendant le traitement successif de réduction la réaction se développe encore plus lentement que dans l'exemple 1 A, et elle est complète après 3 minutes seulement. Après le traitement de réduction la feuille de cuivre montre une couleur rouge-brune, avec la même apparence peu uniforme qu'elle avait avant le traitement de réduction.

Avec la feuille de cuivre ainsi traitée on prépare un circuit feuilleté, puis on fait le mesurage de la résistance à la délamination en employant la même procédure décrite dans l'exemple 1 A. Les valeurs de la résistance à la délamination qu'on obtient dans ce cas sont les suivantes:
- Avant la sollicitation thermique : 1,5 - 1,9 kg/cm
- Après la sollicitation thermique : 1,3 - 1,7 kg/cm

Comme conséquence de l'épaisseur plus réduite de l'oxyde de cuivre de départ, et donc de l'oxyde de cuivre réduit qu'on obtient, ainsi que der la pauvre uniformité superficielle présente, les valeur de la résistance à la délamination qu'on obtient dans ce cas sont quelque peu supérieures, mais elles changent en mesure plus grande que celles obtenues dans les exemples 1 A et 1 B, où l'oxyde de cuivre de départ était noir.

### EXEMPLE 2 B

Une feuille de cuivre de l'épaisseur de 35 microns est traité par la même procédure de l'exemple 2 A, sauf qu'après l'oxidation de la surface de cuivre la feuille de cuivre est soumise à un traitement de réduction moyennant immersion dans un bain suivant l'exemple 1 B, à savoir, comportant dans sa composition la thyourée.

Comme dans l'exemple 2 A, la feuille de cuivre montre, après oxidation, une couleur rouge et une apparence peu uniforme. L'épaisseur de la couche d'oxyde de cuivre qu'on obtient dans ce cas résulte être de 100 nm.

La réaction de réduction de l'oxyde de cuivre se développe, aussi dans ce cas, plus lentement que dans les exemples 1 A et 1 B, et elle est complète après 3 minutes seulement. Après le traitement de réduction la feuille de cuivre montre une couleur rouge-brune, avec la même apparence peu uniforme qu'elle montrait avant le traitement de réduction.

En procédant comme dans les exemples précédents, les valeurs de la résistance à la délamination qu'on obtient dans ce cas sont les suivantes:
- Avant la sollicitation thermique : 1,5 - 1,8 kg/cm
- Après la sollicitation thermique : 1,3 - 1,8 kg/cm

Comme dans l'exemple 2 A, les valeur de la résistance à la délamination qu'on obtient dans ce cas changent en mesure supérieure par rapport à celles obtenues dans les exemples 1 A et 1 B, où l'oxyde de départ était noir.

### EXEMPLE COMPARATIF 2

La même procédure de l'exemple 2 A est répétée, sauf que la feuille de cuivre, après l'oxidation dans le bain suivant l'exemple 2 A, est soumise à un traitement de réduction moyennant immersion en un bain suivant l'exemple comparatif 1, à savoir, un bain qui ne comporte pas un stabilisateur spécifique.

Comme dans les exemples 2 A et 2 B, la feuille de cuivre montre, après oxidation, une couleur rouge et une apparence peu uniforme. L'épaisseur de la couche d'oxyde résulte de 100 nm.

Dans ce cas la réaction de réduction de l'oxyde de cuivre se développe un peu plus énergiquement que dans les exemples 2 A et 2 B, mais bien moins énergiquement que dans l'exemple comparatif 1, et en effet elle est complète après 3 minutes sans que le bain devienne trouble dû à la présence de particules d'oxyde de cuivre suspendu. Après le traitement de réduction la feuille de cuivre montre une couleur rouge-brune mais avec une apparence très peu uniforme.

Les valeurs de la résistance à la délamination qu'on obtient dans ce cas sont les suivantes:
- Avant la sollicitation thermique : 1,2 - 2,1 kg/cm
- Après la sollicitation thermique : 1,1 - 1,6 kg/cm

Les valeur de la résistance à la délamination qu'on obtient dans ce cas, même en changeant beaucoup d'un point à l'autre du circuit, sont toujours élevées, même après la sollicitation thermique. D'autre part, toutefois, l'apparence de la surface de l'oxyde réduit ne résulte pas être acceptable par le marché, qui considérerait le produit comme défectueux.

### EXEMPLES 3 A, 3 B, 3 C ET EXEMPLE COMPARATIF 3

On prépare quatre bains, du volume d'un litre, identiques entr'eux, sauf que le premier comporte dans sa composition le sodium xylensulfonate, le deuxième comporte la thyourée, le troisième comporte tous ces deux composés, et le quatrième ne comporte aucun stabilisateur. Ces quatre bains sont donc caractérisés par les suivantes compositions:

### Bain No. 1 (Exemple 3 A):

| | |
|---|---|
| Diméthylaminoborane: | 1,5 g/l |
| Sodium hydroxyde: | 20 g/l |
| Sodium xylènesulfonate: | 2 g/l |
| Eau déionisée jusqu'à: | 1 l |

### Bain No. 2 (Exemple 3 B):

| | |
|---|---|
| Diméthylaminoborane: | 1,5 g/l |
| Sodium hydroxyde: | 20 g/l |
| Thiourée: | 2 mg/l |
| Eau déionisée jusqu'à: | 1 l |

### Bain No. 3 (Exemple 3 C):

| | |
|---|---|
| Diméthylaminoborane: | 1,5 g/l |
| Sodium hydroxyde: | 20 g/l |
| Sodium xylènesulfonate: | 2 g/l |
| Thiourée: | 2 mg/l |
| Eau déionisée jusqu'à: | 1 l |

### Bain No. 4 (Exemple comparatif 3):

| | |
|---|---|
| Diméthylaminoborane: | 1,5 g/l |
| Sodium hydroxyde: | 20 g/l |
| Eau déionisée jusqu'à: | 1 l |

Dans ces quatre bains on traite, parallèlement, à une température de 25 °C et pendant un temps de traitement de 5 minutes, des pièces de laminé de cuivre de 2 dm de surface, préalablement oxidées suivant la procédure dont à l'exemple 1 A. Pendant la réaction de réduction de l'oxyde de cuivre, tandis que dans le bain No. 4 on remarque un fort développement de gaz, surtout pendant la première minute du traitement, dans les bains No. 1, No. 2 et No. 3 a lieu une réaction bien plus régulière. De plus, tandis que le bain No. 4, après traitement de deux ou trois pièces de laminé, devient trouble, dans les bains No. 1, No. 2 et No. 3 on ne remarque aucune formation de précipité. Après avoir traité 50 dm de surface par 1 litre de bain on analyse les quatre bains afin d'établir la quantité de diméthylaminoborane encore contenue dans ces bains, laquelle résulte comme suit:

| | |
|---|---|
| Bain No. 1: | 1,20 g/l |
| Bain No. 2: | 1,22 g/l |
| Bain No. 3: | 1,80 g/l |
| Bain No. 4: | 0,90 g/l |

La consommation de diméthylaminoborane qui a eu lieu dans les bains No. 1, No. 2 et No. 3 est réduite du 50 % par rapport à la consommation dans le bain No. 4. Ces quatre bains sont laissés en repos pendant 48 heures, puis analysés à nouveau. Les valeurs qu'on obtient de cette deuxième analyse sont les suivantes:

| | |
|---|---|
| Bain No. 1: | 1,18 g/l |
| Bain No. 2: | 1,20 g/l |
| Bain No. 3: | 1,30 g/l |
| Bain No. 4: | 0,70 g/l |

Ces données confirment que les bains No. 1, No. 2 et No. 3, qui comportent un ou deux composés suivant la présente invention, se montrent bien plus stables que le bain No. 4, soit pendant le travail, soit aussi pendant les arrêts du travail. De plus, le bain No. 3 résulte être le plus stable, mettant ainsi en évidence une certaine action synergique entre les composés stabilisateurs choisis, respectivement, dans les classes (A) et (B) ci-dessus indiquées.

### EXEMPLE 4

Une couche interne ayant le cuivre encore présent sur les deux faces est traitée par la même procédure de l'exemple 1 A.

Cette couche interne ainsi traitée est utilisée pour préparer un circuit feuilleté en superposant sur les deux faces trois feuilles de "prepreg" et une feuille de cuivre de l'épaisseur de 35 microns. Le sandwich ainsi préparé est laminé en travaillant suivant les paramètres traditionnels. Le circuit feuilleté ainsi obtenu est percé en travaillant de la façon habituelle, réalisant 10.000 trous des diamètres de 0,3 mm, de 0,6 mm et de 1 mm.

Le circuit feuilleté percé est ensuite soumis à un traitement de "desmear" par du permanganate, qui comprend les trois phases suivantes:
- Conditionnement en un solvant organique (CUPROLITE PHP produit par Alfachimici s.r.l.) contenant le 10 % d'eau, à une température de 35 °C et pendant un temps de 3 minutes, suivi par un double lavage par de l'eau.
- Traitement de "desmear" proprement dit, par une solution de permanganate (EPOXYMOD MLX 60 produit par Alfachimici s.r.l.) contenant 60 g/l de KMnO₄ et travaillant à une alcalinité de 1 N, pour une durée de 12 minutes à une température de 80 °C, suivi par un double lavage par de l'eau.
- Réduction du permanganate par une solution réductrice (FINISHER MLX 100 produit par Alfachimici s.r.l.) pour une durée de 5 minutes à une température de 40 °C, suivie par un double lavage par de l'eau.

Après le traitement complet de "desmear" le circuit feuilleté est métallisé suivant un procès de métallisation traditionnel comprenant les suivant traitements:
- Conditionnement des parois des trous par un conditionneur neutral (CU-PROLITE X-84 produit par Alfachimici s.r.l.) à une température de 65 °C pour une durée de 5 minutes, suivi par un double lavage par de l'eau.
- Mordençage par une solution à base d'eau oxygénée (MICROINCIDE 1207 produit par Alfachimici s.r.l.) pour une durée de 3 minutes à une température de 25 °C, suivi par un double lavage par de l'eau.
- Traitement par un produit de pré-catalyse (UNIPHASE MLX A produit par Alfachimici s.r.l.) à une température de 25 °C pour une durée de 1 minute.
- Traitement de catalyse par un catalyseur à base de palladium colloïdal (UNIPHASE MLX (A+B) produit par Alfachimici s.r.l. à une température de 30 °C pour une durée de 5 minutes, suivi par un double lavage par de l'eau.
- Traitement par un produit d'accélération (DRAG-STOP MLX 84 produit par Alfachimici s.r.l.) à une température de 25 °C pour une durée de 4 minutes, suivi par un seul lavage par de l'eau.
- Traitement par un produit de déposition chimique de cuivre (CUPROTHICK 84 produit par Alfachimici s.r.l.) à une température de 38 °C pour une durée de 30 minutes, suivi par un double lavage par de l'eau.

Le circuit feuilleté ainsi métallisé est soumis à un traitement de déposition électrolytique de cuivre, soit en surface, soit dans les trous, jusqu'à une épaisseur de 25 microns (employant un bain PENETRA MLX 86 produit par Alfachimici s.r.l.). A' ce point le circuit feuilleté est examiné pour évaluer la présence de "pink-ring". Afin de pouvoir examiner le circuit tout entier (10.000 trous) on attaque par un produit ammoniacal (ULTRAINCIDE 35/35 produit par Alfachimici s.r.l.) soit la couche de cuivre électrolytique (25 microns) soit la couche de cuivre de base (35 microns) de la surface du circuit. De cette façon on emporte entièrement le cuivre de la paroi du trou et, de plus, on attaque en partie les couches internes de cuivre sur la paroi du trou. Cette condition permet de mettre bien en évidence la présence éventuelle de "pink-ring". Sur les 10.000 trous examinés, le "pink-ring" est à peine visible en 15 trous, avec une extension toujours inférieure à 100 microns. En outre, le circuit feuilleté attaqué montre en surface une couleur noire et une apparence uniforme.

### EXEMPLE COMPARATIF 4

Une couche interne est soumise à la même procédure de l'exemple 4, sauf que la couche interne oxidée n'est pas soumise au traitement de réduction par la composition objet de la présente invention. Le circuit feuilleté attaqué qu'on obtient montre en surface une couleur noire uniforme comme celle obtenue dans l'exemple 4. Ce circuit est examiné comme dans l'exemple 4, et on remarque la présence de "pink-ring" dans tous les trous du circuit; de plus, dans le 30 % des trous la dimension du "pink-ring" est supérieure à 500 microns.

Comme il ressort clairement des exemples et exemples comparatifs qui précèdent, les procédés et la composition suivant la présente invention permettent d'atteindre effectivement les buts proposés, en améliorant substantiellement l'adhérence entre le cuivre et le matériau polymérique même après sollicitation thermique, en réduisant ou pratiquement supprile phénomène du "pink-ring", et en réduisant considérablement les frais dus à la consommation des produits employés. Comme on le comprendra, le procédé selon l'invention peut être appliqué indifféremment à la production de circuits feuilletés rigides, flexibles et flexo-rigides.

Les quantités indiquées des composants doivent, bien entendu, être référées aux conditions d'emploi tandis que la composition suivant l'invention peut être aussi réalisée pour le commerce en une forme plus concentrée, destinée à être diluée pour l'emploi.

On doit comprendre que la description précédente n'est pas limitative du domaine de l'invention, et que différentes modifications, à la portée du technicien expert, et tout remplacement par des équivalents techniques, peuvent être portés sans pour cela sortir du cadre de l'invention et du domaine de ce brevet, comme précisé par les revendications suivantes.

## Revendications

1. Procédé pour le traitement des surfaces de cuivre afin de promouvoir l'adhérence entre différentes couches dans la fabrication de circuits imprimés feuilletés, rigides, flexibles ou flexo-rigides, moyennant la formation d'une couche d'oxyde sur les surfaces de cuivre et un traitement ultérieur de réduction de l'oxyde de cuivre dans une solution comportant dans sa composition du diméthylaminoborane et une base forte,
caractérisé en ce que le traitement de réduction, successif à la phase d'oxidation de la surface de cuivre, est effectué dans une solution réductrice comportant dans sa composition, en plus du diméthylaminoborane et d'une base forte, un composé spécifique ayant fonction stabilisante et ralentissante, ledit composé étant choisi dans le groupe comprenant:
(A) Un alcoylbenzènesulfonate alcalin, à savoir un composé de la formule générale: C₆H₃.R.R'.SO₃X où R et R' peuvent être H, CH₃ ou C₂H₅, et X est un métal alcalin, spécialement Na.
(B) Un composé de la thiourée ou ses homologues de sélénium ou tellurium de la formule générale: C.Y.N₂.R¹.R.R³.R⁴ où R¹, R, R³, R⁴ peuvent être:
(a) H,
(b) un groupe alcoylique ou alcènilique comprenant un nombre d'atomes de carbone non supérieur à 6,
(c) un groupe cycloalcoylique, cycloalcoylalcoylique ou alcoylcycloalcoylique comprenant un nombre d'atomes de carbone non supérieur à 12,
(d) un groupe arylique, arylalcoylique ou alcoylarylique comprenant un nombre d'atomes de carbone non supérieur à 12,
(e) R⁵(CO), où R⁵ peut être un quelconque des composés indiqués de (a) à (d),
(f) CH₂OH;
et Y peut être S, Se ou Te;
(C) un composé de la thiourée avec des acides organiques ou inorganiques;
(D) un mélange de deux ou plusieurs des composés indiqués de (A) à (C).

2. Procédé suivant la revendication 1, caractérisé en ce que le traitement de réduction de l'oxyde de cuivre est effectué dans une solution qui comporte dans sa composition, comme alcoylbenzènesulfonate alcalin de la classe (A), le sodium xylènesulfonate.

3. Procédé suivant la revendication 1 ou 2, caractérisé en ce que ledit alcoylbenzènesulfonate alcalin est présent en une concentration supérieure à 0,1 g/l, et de préférence comprise entre 0,5 g/l et 5 g/l.

4. Procédé suivant la revendication 1, caractérisé en ce que le traitement de réduction de l'oxyde de cuivre est effectué dans une solution qui comporte dans sa composition, comme composé de la classe (B), la thiourée.

5. Procédé suivant la revendication 1 ou 4, caractérisé en ce que ledit composé de la classe (B) et/ou (C) est présent en une concentration comprise entre 0,1 mg/l et 100 mg/l, et de préférence comprise entre 0,5 mg/l et 2 mg/l.

6. Procédé suivant la revendication 1, caractérisé en ce que le dimethylaminoborane est présent en une concentration comprise entre 0,1 g/l, et 100 g/l, et de préférence comprise entre 0,5 g/l et 5 g/l.

7. Procédé suivant la revendication 1, caractérisé en ce que ladite base forte est constituée par du sodium hydroxyde, présent en une concentration entre 1 g/l et 100 g/l, et de préférence comprise entre 10 g/l et 30 g/l.

8. Procédé suivant la revendication 1, caractérisé en ce que, dans son exécution, la solution pour le traitement de réduction de l'oxyde de cuivre travaille à une température comprise entre 20 °C et 60 °C, et de préférence comprise entre 20 °C et 30 °C.

9. Procédé suivant la revendication 1, caractérisé en ce que, dans son exécution, la période de traitement dans la solution de réduction de l'oxyde de cuivre est comprise entre 10 sécondes et 15 minutes, et de préférence comprise entre 2 minutes et 6 minutes.

10. Procédé suivant la revendication 1, caractérisé en ce que le contact entre la solution de réduction et la surface qui porte l'oxyde de cuivre a lieu par immersion ou par aspersion.

11. Procédé pour la fabrication de circuits imprimés feuilletés, caractérisé en ce qu'il comprend les phases suivantes:
a) préparer un certain nombre de couches internes constituées par un substrat non conducteur, rigide ou flexible, couvert sur les deux côtés par des minces feuilles de cuivre, ledit substrat pouvant être constitué par un tissu de fibre de verre ou par du papier, imprégné par de la résine époxyde, polyimide ou phénolique, ou bien par une feuille de résine époxyde, polyimide ou phénolique.
b) Emporter sélectivement le cuivre par une opération d'attaque chimique, des deux côtés des couches internes, jusqu'à obtenir la figure du circuit interne.
c) Traiter les surfaces de cuivre desdites couches internes par un procédé suivant une quelconque des revendications 1 à 10.
d) Laminer, sous l'action combinée de chaleur et de pression, un ou plusieurs couches internes, préparées suivant la procédure de a) à c), en les séparant par un ou plusieurs couches de matériau non conducteur, constitué par un tissu de fibre de verre ou par du papier, imprégné par de la résine époxyde, polyimide ou phénolique, ou bien par une feuille de résine époxyde, polyimide ou phénolique, et recouvrant leurs faces extérieures par deux feuilles de cuivre.
e) Percer le circuit feuilleté ainsi obtenu en réalisant des trous traversants, dans le nombre et dans les positions prévues.
f) Soumettre à un traitement de "desmear" et de métallisation les parois des trous traversants.
g) Emporter sélectivement le cuivre des faces extérieures par une opération d'attaque chimique, ainsi obtenant la figure de circuit désirée.

12. Procédé suivant la revendication 11, caractérisé en ce qu'aussi les deux feuilles de cuivre appliqués sur les faces extérieures du circuit feuilleté sont traités, avant la lamination, par un procédé suivant une quelconque des revendications 1 à 10.

13. Procédé pour la fabrication de circuits imprimés feuilletés flexibles, comprenant les phases suivantes:
a) Coller deux feuilles de cuivre, traités suivant une quelconque des revendications 1 à 10, à une couche de résine flexible constituée par polyimide, polyester, polysulfone ou polytetrafluoroéthylène, en utilisant un collant à base de résine époxyde ou acrylique.
b) Emporter par un attaque chimique, de la surface de ces couches internes, le cuivre où il n'est pas requis, en obtenant la figure du circuit.
c) Traiter la surface de cuivre par un procédé suivant une quelconque des revendications 1 à 10.
d) Coller un ou plusieurs couches internes flexibles préparées suivant la procédure de a) à c) en utilisant un collant à base de résine époxyde ou acrylique.

14. Composition pour la réduction d'une couche d'oxyde de cuivre destinée à constituer un promoteur d'adhérence entre le cuivre et un matériau polymérique dans la fabrication de circuits imprimés feuilletés, du type d'une solution contenant du diméthylaminoborane et une base forte,
caractérisée en ce qu'elle contient en outre un composé spécifique ayant une fonction de stabilisation et de ralentissement, choisi dans le groupe comprenant:
(A) Un alcoylbenzènesulfonate alcalin, à savoir un composé de la formule générale: C₆H₃.R.R'.SO₃X où R et R' peuvent être H, CH₃ ou C₂H₅, et X est un métal alcalin, spécialement Na.
(B) Un composé de la thiourée ou ses homologues de sélénium ou tellurium de la formule générale: C.Y.N₂.R¹.R.R³.R⁴ où R¹, R, R³, R⁴ peuvent être:
(a) H,
(b) un groupe alcoylique ou alcènilique comprenant un nombre d'atomes de carbone non supérieur à 6,
(c) un groupe cycloalcoylique, cycloalcoylalcoylique ou alcoylcycloalcoylique comprenant un nombre d'atomes de carbone non supérieur à 12,
(d) un groupe arylique, arylalcoylique ou alcoylarylique comprenant un nombre d'atomes de carbone non supérieur à 12,
(e) R⁵(CO), où R⁵ peut être un quelconque des composés indiqués de (a) à (d),
(f) CH₂OH;
et Y peut être S, Se ou Te;
(C) un composé de la thiourée avec des acides organiques ou inorganiques;
(D) un mélange de deux ou plusieurs des composés indiqués de (A) à (C).

15. Composition suivant la revendication 14, caractérisée en ce que le sodium alcoylbenzènesulfonate de la classe (A) est constitué par du sodium xylènesulfonate.

16. Composition suivant la revendication 14 ou 15, caractérisée en ce que ledit alcoylbenzènesulfonate alcalin est présent, dans les conditions d'emploi, en une concentration supérieure à 0,1 g/l, et de préférence comprise entre 0,5 g/l et 5 g/l.

17. Composition suivant la revendication 14, caractérisée en ce qu'elle comporte dans sa composition, comme composé de la classe (B), la thiourée.

18. Composition suivant la revendication 14 ou 17, caractérisée en ce que ledit composé de la classe (B) et/ou (C) est présent en une concentration comprise entre 0,1 mg/l et 100 mg/l, et de préférence comprise entre 0,5 mg/l et 2 mg/l.

19. Composition suivant la revendication 14, caractérisée en ce que le dimethylaminoborane est présent, dans les conditions d'emploi, en une concentration comprise entre 0,1 g/l et 100 g/l, et de préférence comprise entre 0,5 g/l et 5 g/l.

20. Composition suivant la revendication 14, caractérisée en ce que ladite base forte est constituée par du sodium hydroxyde, présent, dans les conditions d'emploi, en une concentration entre 1 g/l et 100 g/l, et de préférence comprise entre 10 g/l et 30 g/l.

## Patentansprüche

1. Verfahren zur Behandlung der Kupferflächen, um die Haftung zwischen den verschiedenen Schichten bei der Herstellung von biegesteifen, biegsamen oder teilweise biegesteifen, gedruckten Leiterplatten aus Schichtpresstoff durch die Bildung einer Oxydschicht auf die Kupferflächen und durch eine anschliessende Behandlung zur Reduktion des Kupferoxyds in einer Lösung, in deren Zusammensetzung Dimethylaminoboran und eine starke Lauge enthalten sind,
dadurch gekennzeichnet, dass die der Oxydationsphase der Kupferfläche folgende Reduktionsbehandlung in einer Reduktionslösung erfolgt, in deren Zusammensetzung ausser dem Dimethylaminoboran und der starken Lauge eine spezifische Verbindung enthalten ist, die eine stabilisierende und bremsende Wirkung hat, wobei diese Verbindung in der Gruppe gewählt wird, die:
(A) ein alkalisches Alkylbenzolsulfonat, d.h. eine Verbindung der allgemeinen Formel : C₆H₃.R.R'.SO₃.X, wobei R und R' H, CH₃ oder C₂H₅ sein können und X ein Alkalimetall, insbesondere Na, ist;
(B) eine Verbindung des Thioharnstoffes oder dessen Homologstoffe aus Selen oder Tellur, der allgemeinen Formel: C.Y.N.₂.R¹.R.R³.R⁴ , wobei R¹, R, R³, R⁴ :
(a) H,
(b) eine Alkyl- oder Alkenylgruppe mit einer Anzahl von nicht mehr als 6 Kohlenstoffatomen,
(c) eine Zycloalkyl-, Zycloalkylalkyl- oder Alkylzycloalkyl-gruppe mit einer Anzahl von nicht mehr als 12 Kohlenstoffatomen,
(d) eine Aryl-, Arylalkyl- oder Alkylarylgruppe mit einer Anzahl von nicht mehr als 12 Kohlenstoffatomen,
(e) R⁵(CO), wobei R⁵ irgendeine der unter (a) bis (d) angegebenen Verbindungen sein kann,
(f) CHOH
sein können, und Y S, Se oder Te sein kann;
(C) eine Verbindung des Thioharnstoffes mit organischen oder anorganischen Säuren;
(D) eine Mischung von zwei oder mehr der unter (A) und (C) angegebenen Verbindungen;
enthält.

2. Verfahren nach Anspruch 1, dadurch gekennzeichnet, dass die Behandlung zur Reduktion des Kupferoxyds in einer Lösung erfolgt, in deren Zusammensetzung Natrium-Xylensulfonat als alkalisches Alkylbenzolsulfonat der Klasse (A) enthalten ist.

3. Verfahren nach Anspruch 1 oder 2, dadurch gekennzeichnet, dass das alkalische Alkylbenzolsulfonat in einer Konzentration von mehr als 0,1 g/l, vorzugsweise von 0,5 g/l bis 5 g/l, vorliegt.

4. Verfahren nach Anspruch 1, dadurch gekennzeichnet, dass die Behandlung zur Reduktion des Kupferoxyds in einer Lösung erfolgt, in deren Zusammensetzung Thioharnstoff als Verbindung der Klasse (B) enthalten ist.

5. Verfahren nach Anspruch 1 oder 4, dadurch gekennzeichnet, dass die Verbindung der Klasse (B) und/oder (C) in einer Konzentration von 0,1 mg/l bis 100 mg/l, vorzugsweise von 0,5 mg/l bis 2 mg/l, vorliegt.

6. Verfahren nach Anspruch 1, dadurch gekennzeichnet, dass das Dimethylaminoboran in einer Konzentration von 0,1 g/l bis 100 g/l, vorzugsweise von 0,5 g/l bis 5 g/l, vorliegt.

7. Verfahren nach Anspruch 1, dadurch gekennzeichnet, dass die starke Lauge aus Natriumhydroxyd besteht, das in einer Konzentration von 1 g/l bis 100 g/l, vorzugsweise von 10 g/l bis 30 g/l, vorliegt.

8. Verfahren nach Anspruch 1, dadurch gekennzeichnet, dass während seiner Ausführung die Behandlung zur Reduktion des Kupferoxyds bei einer Temperatur zwischen 20°C und 60°C, vorzugsweise zwischen 20°C und 30°C, vorgenommen wird.

9. Verfahren nach Anspruch 1, dadurch gekennzeichnet, dass während seiner Ausführung die Dauer der Behandlung mit der Reduktionslösung des Kupferoxyds 10 Sekunden bis 15 Minuten, vorzugsweise 2 Minuten bis 6 Minuten, beträgt.

10. Verfahren nach Anspruch 1, dadurch gekennzeichnet, dass die Berührung zwischen der Reduktionslösung und der das Kupferoxyd tragenden Fläche mit einem Tauch- oder einem Spritzvorgang erfolgt.

11. Verfahren zur Herstellung von gedruckten Leiterplatten aus Schichtpresstoff, dadurch gekennzeichnet, dass es folgenden Stufen umfasst:
a) Vorbereitung einer bestimmten Anzahl Innenschichten, die aus einem nicht leitenden steifen oder biegsamen Substrat bestehen, das an beiden Seiten mit dünnen Kupferfolien bedeckt ist, wobei dieses Substrat aus einem mit Epoxyd-, Polyimid- oder Phenolharz getränkten Glasfaser- oder Papierstoff oder aus einer Epoxyd- Polyimid- oder Phenolharzfolie bestehen kann;
b) Selektives Entfernen, d.h. Wegätzen, des Kupfers von beiden Seiten der Innenschichten, bis das Bild der Innenschaltung erscheint;
c) Behandlung der Kupferflächen der Innenschichten mit einem Verfahren nach irgendeinem der Ansprüche 1 bis 10;
d) Laminieren von einer oder mehreren, nach des Stufen a) bis c) vorbereiteten Innenschchten durch die kombinierte Wirkung von Wärme und Druck, wobei die Innenschichten durch eine oder mehrere Schichten aus nicht leidendem Material getrennt werden, das aus einem mit Epoxyd-, Polyimid- oder Phenolharz getränkten Glasfaser- oder Papierstoff oder aus einer Epoxyd-, Polyimid- oder Phenolharzfolie besteht, und die beiden Aussenseiten mit zwei Kupferfolien bedeckt werden;
e) Die so erhaltene Schaltung wird an der vorgesehenen Stellen mit der vorgesehenen Anzahl Durchgangslöcher versehen;
f) "Desmear"-Behandlung und Metallisierung der Wandungen der Durchgangslöcher;
g) Selektives Entfernen, d.h. Wegätzen, des Kupfers von den Aussenseiten bis das Bild der gewünschten Schaltung erscheint.

12. Verfahren nach Anspruch 11, dadurch gekennzeichnet, dass vor dem Laminieren die beiden an den Aussenseiten der Schaltung aus Schichtpresstoff angebrachten Kupferfolien ebenfalls mit einem Verfahren nach irgendeinem der Ansprüche 1 bis 10 behandelt werden.

13. Verfahren zur Herstellung von biegsamen gedruckten Leiterplatten aus Schichtpresstoff, dadurch gekennzeichnet, dass es folgenden Stufen umfasst:
a) Ankleben von zwei mit einem Verfahren nach irgendeinem der Ansprüche 1 bis 10 behandelten Kupferfolien an eine biegsame Harzschicht, die aus Polyimid, Polyester, Polysulfon oder Polytetrafluoräthylen besteht, wobei ein Kleber auf Epoxyd- oder Akrylharzbasis benutzt wird;
b) Entfernen, d.h. Wegätzen, der nicht notwendigen Kupferteile von der Oberfläche dieser Innenschichten, bis das Bild der Schaltung erscheint;
c) Behandlung der Kupferfläche mit einem Verfahren nach irgendeinem der Ansprüche 1 bis 10;
d) Ankleben von einer oder mehreren, nach den Stufen a) bis c) vorbereiteten biegsamen Innen schichten durch Anwendung eines Klebers auf Epoxyd- oder Akrylharzbasis.

14. Zusammensetzung zur Reduktion einer Kupferoxydschicht zur Haftvermittlung zwischen dem Kupfer und einem Polymerstoff bei der Herstellung von gedruckten Leiterplatten aus Schichtpresstoff, wobei eine Lösung verwendet wird, die Dimethylaminoboran und eine starke Lauge enthält,
dadurch gekennzeichnet, dass die Lösung ausserdem eine spezifische Verbindung enthält, die eine stabilisierende und bremsende Wirkung hat und in der Gruppe gewählt wird, die:
(A) ein alkalisches Alkylbenzolsulfonat, d.h. eine Verbindung der allgemeinen Formel : C₆H₃.R.R'.SO₃.X, wobei R und R' H, CH₃ oder C₂H₅ sein können und X ein Alkalimetall, insbesondere Na, ist;
(B) eine Verbindung des Thioharnstoffes oder dessen Homologstoffe aus Selen oder Tellur, der allgemeinen Formel: C.Y.N₂.R¹.R.R³.R⁴, wobei R¹, R, R ³, R⁴ :
(a) H,
(b) eine Alkyl- oder Alkenylgruppe mit einer Anzahl von nicht mehr als 6 Kohlenstroffatomen,
(c) eine Zycloalkyl-, Zycloalkylalkyl- oder Alkylzycloalkyl- gruppe mit einer Anzahl von nicht mehr als 12 Kohlenstoffatomen,
(d) eine Aryl-, Arylalkyl- oder Alkylarylgruppe mit einer Anzahl von nicht mehr als 12 Kohlenstoffatomen,
(e) R⁵(CO), wobei R⁵ irgendeine der unter (a) bis (d) angegebenen Verbindungen sein kann,
(f) CH₂OH
sein können, und Y S, Se oder Te sein kann;
(C) eine Verbindung des Thioharnstoffes mit organischen oder anorganischen Säuren;
(D) eine Mischung von zwei oder mehr der unter (A) bis (C) angegebenen Verbindungen enthält.

15. Zusammensetzung nach Anspruch 14, dadurch gekennzeichnet, dass das Natrium-Alkylbenzolsulfonat der Klasse (A) Natrium-Xylensulfonat ist.

16. Zusammensetzung nach Anspruch 14 oder 15, dadurch gekennzeichnet, dass das verwendete alkalische Alkylbenzolsulfonat in einer Konzentration von mehr als 0,1 g/l, vorzugsweise von 0,5 g/l bis 5 g/l, vorliegt.

17. Zusammensetzung nach Anspruch 14, dadurch gekennzeichnet, dass sie Thioharnstoff als Verbindung der Klasse (B) enthält.

18. Zusammensetzung nach Anspruch 14 oder 17, dadurch gekennzeichnet, dass die Verbindung der Klasse (B) und/oder (C) in einer Konzentration von 0,1 mg/l bis 100 mg/l, vorzugsweise von 0,5 mg/l bis 2 mg/l, vorliegt.

19. Zusammensetzung nach Anspruch 14, dadurch gekennzeichnet, dass das verwendete Dimethylaminoboran in einer Konzentration von 0,1 g/l bis 100 g/l, vorzugsweise von 0,5 g/l bis 5 g/l, vorliegt.

20. Zusammensetzung nach Anspruch 14, dadurch gekennzeichnet, dass die verwendete starke Lauge Natriumhydroxyd ist, das in einer Konzentration von 1 g/l bis 100 g/l, vorzugsweise von 10 g/l bis 30 g/l, vorliegt.

## Claims

1. A process for treating copper surfaces, in order to promote the adhesion between the various layers in the manufacture of multi-layered, rigid, flexible or semiflexible printed circuits, by means of the formation of an oxide layer on the copper surfaces, and of a subsequent reduction treatment of the copper oxide in a solution containing in its composition dimethylaminoborane and a strong base,
characterized in that the reduction treatment, subsequent to the step of oxidation of the copper surfaces, is effected in a reduction solution containing in its composition, in addition to the dimethylaminoborane and a strong base, a specific compound with stabilizing and slackening function, said compound being selected in the group comprising:
(A) an alcaline alkylbenzene sulfonate, namely a compound of the general formula: C₆H₃.R.R'.SO₃.X where R ed R' may be H, CH₃ or C₂H₅ and X is an alcaline metal, especially Na;
(B) a compound of the thiourea or its homologous of selenium or tellurium, of the general formula: C.Y.N₂.R¹.R.R³.R⁴ where R¹, R, R³ and R⁴ may be:
(a) H,
(b) an alkylic or alkenilic group containing a number of carbon atoms not higher than 6,
(c) a cycloalkylic, cycloalkylalkylic o alkylcycloalkylic group containing a number of carbon atoms not higher than 12,
(d) an arylic, arylalkylic or alkylarylic group containing a number of carbon atoms not higher than 12,
(e) R⁵(CO), where R⁵ may be any of the compounds stated under (a) to (e),
(f) CH₂OH;
and Y may be S, Se or Te;
(C) a compound of the thiourea with organic or inorganic acids;
(D) a mixture of two or more compounds stated from (A) to (C).

2. A process as set forth in Claim 1, characterized in that the reduction treatment of the copper oxide is effected in a solution including in its composition, as an alcaline alkylbenzene sulfonate of the class (A), the sodium xylensulfonate.

3. A process as set forth in Claim 1 or 2, characterized in that the alcaline alkylbenzene sulfonate is present in a concentration higher than 0,1 g/l and preferably ranging from 0,5 g/l to 5 g/l.

4. A process as set forth in Claim 1, characterized in that the reduction treatment of the copper oxide is effected in a solution including in its composition, as a compound of the class (B), the thiourea.

5. A process as set forth in Claim 1 or 4, characterized in that said compound of the class (B) and/or (C) is present in a concentration ranging from 0,1 mg/l to 100 mg/l, and preferably ranging from 0,5 mg/l to 2 mg/l.

6. A process as set forth in Claim 1, characterized in that the dimethylaminoborane is present in a concentration ranging from 0,1 g/l to 100 g/l and preferably ranging from 0,5 g/l to 5 g/l.

7. A process as set forth in Claim 1, characterized in that said strong base is formed by sodium hydroxide, present in a concentration ranging from 1 g/l to 100 g/l, and preferably ranging from 10 g/l to 30 g/l.

8. A process as set forth in Claim 1, characterized in that, in performing the same, the solution for the reduction treatment of the copper oxide operates at a temperature ranging from 20 °C to 60 °C and preferably ranging from 20 °C to 30 °C.

9. A process as set forth in Claim 1, characterized in that, in performing the same, the treatment period in the reduction solution for the copper oxide ranges from 10 seconds to 15 minutes, and preferably from 2 minutes and 6 minutes.

10. A process as set forth in Claim 1, characterized in that the contact between the reduction solution and the surface which carries the copper oxide is effected by dipping or by spraying.

11. A process for the manufacture of multi-layered printed circuits, characterized in that it comprises the following steps:
a) To prepare a certain number of inner layers formed by a non conductive, rigid or flexible substrate, covered on both sides by thin copper sheets, said substrate being formed by a tissue of glass fibers or by paper, impregnated with epoxydic, polyimidic or phenolic resin, or by a sheet of epoxydic, polyimidic or phenolic resin.
b) To selectively remove the copper by an operation of chemical attack, from both faces of the inner layers, until obtaining the figure of the inner circuit.
c) To treate the copper surfaces of said inner layers by a process according to any one of the Claims from 1 to 10.
d) To laminate, under the combined action of heath and pressure, one or more inner layers, prepared according to the procedure from a) to c), by separating them by means of one or more layers of a non conductive material, formed by a tissue of glass fibers or paper, impregnated with epoxydic, phenolic or polyimidic resin, or by a sheet of an epoxydic, phenolic or polyimidic resin, and covering both their outer faces by two copper sheets.
e) To pierce the thus obtained multi-layer by providing through bores in the foreseen number and positions.
f) To submit to desmear and metallization treatments the walls of the through bores.
g) To selectively remove the copper from the outer faces by an operation of chemical attack, thus obtaining the desired figure of the circuit.

12. A process as set forth in Claim 11, characterized in that also both the copper sheets applied on the outer faces of the multi-layer circuit are treated, before their lamination, by a process according to any one of the Claims from 1 to 10.

13. A process for the manufacture of flexible multi-layered printed circuits, including the following steps:
a) To stick two copper sheets, treated by a process according to any one of the Claims from 1 to 10, to a layer of a flexible resin formed by polyimide, polyester, polysulfone or polytetrafluoroethylene, by using an adhesive based on an epoxydic or acrylic resin.
b) To remove, by means of a chemical attack, from the surface of these inner layers, the copper where it is not required, by obtaining the figure of the circuit.
c) To treate the copper surface by a process according to any one of the Claims from 1 to 10.
d) To stick together one or more inner flexible layers prepared according to the procedure from a) to c) by using an adhesive based on an epoxydic or acrylic resin.

14. A composition for the reduction of a layer of copper oxide intended to form an adhesion promoter between the copper and a polymeric material in the manufacture of multi-layered printed circuits, of the type of a solution containing dimethylaminoborane and a strong base,
characterized in that it contains in addition a specific compound with stabilizing and slackening function, selected in the group including:
(A) an alcaline alkylbenzene sulfonate, namely a compound of the general formula: C₆H₃.R.R'.SO₃.X where R and R' may be H, CH₃ or C₂H₅ and X is an alcaline metal, especially Na;
(B) a compound of the thiourea or its homologous of selenium or tellurium, of the general formula: C.Y.N₂.R¹.R.R³.R⁴ where R¹, R, R³ and R⁴ may be:
(a) H,
(b) an alkylic or alkenylic group containing a number of carbon atoms not higher than 6,
(c) a cycloalkylic, cycloalkylalkylic or alkylcycloalckylic group containing a number of carbon atoms not higher than 12,
(d) an arylic, arylalkylic or alkylarylic group containing a number of carbon atoms not higher than 12,
(e) R⁵(CO), where R⁵ may be any one of the compounds stated from (a) to (d),
(f) CH₂OH;
and Y may be S, Se or Te;
(C) a compound of the thiourea with organic or inorganic acids;
(D) a mixture of two or more compounds stated from (A) to (C).

15. A composition as set forth in Claim 14, characterized in that the sodium alkylbenzenesulfonate of the class (A) is formed by sodium xylensulfonate.

16. A composition as set forth in Claim 14 or 15, characterized in that the alcaline alkylbenzene sulfonate is present, in the conditions of use, in a concentration higher than 0,1 g/l and preferably ranging from 0,5 g/l to 5 g/l.

17. A composition as set forth in Claim 14, characterized in that it includes in its composition, as a compound of the class (B), the thiourea.

18. A composition as set forth in Claim 14 or 17, characterized in that the compound of the class (B) and/or (C) is present in a concentration ranging from 0,1 mg/l to 100 mg/l, and preferably ranging from 0,5 mg/l to 2 mg/l.

19. A composition as set forth in Claim 14, characterized in that the dimethylaminoborane is present, in the conditions of use, in a concentration ranging from 0,1 g/l to 100 g/l and preferably ranging from 0,5 g/l to 5 g/l.

20. A composition as set forth in Claim 14, characterized in that said strong base is sodium hydroxide, present, in the conditions of use, in a concentration ranging from 1 g/l to 100 g/l, and preferably ranging from 10 g/l to 30 g/l.
